(19) Europäisches Patentamt
European Patent Office
Office européen des brevets

(11) **EP 4 369 607 A1**

(12) **EUROPEAN PATENT APPLICATION**
published in accordance with Art. 153(4) EPC

(43) Date of publication:
**15.05.2024  Bulletin 2024/20**

(21) Application number: **22836823.9**

(22) Date of filing: **01.07.2022**

(51) International Patent Classification (IPC):
**H03K 17/975** (2006.01)  **H03K 17/96** (2006.01)

(52) Cooperative Patent Classification (CPC):
Y02E 60/10

(86) International application number:
**PCT/CN2022/103334**

(87) International publication number:
**WO 2023/280072 (12.01.2023 Gazette 2023/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **08.07.2021  CN 202110771201**

(71) Applicant: **Vivo Mobile Communication Co., Ltd.
Dongguan, Guangdong 523863 (CN)**

(72) Inventors:
• **SHANG, Zhenxing
  Dongguan, Guangdong 523863 (CN)**
• **CHENG, Baojia
  Dongguan, Guangdong 523863 (CN)**

(74) Representative: **Lavoix
Bayerstraße 83
80335 München (DE)**

(54) **PRESSURE-SENSITIVE KEY AND ELECTRONIC DEVICE**

(57)    This application provides a pressure sensitive button and an electronic device. The pressure sensitive button includes a first circuit board, a second circuit board, a first capacitor, a second capacitor, and a first connector, where a first surface of the first circuit board is disposed opposite to a second surface of the second circuit board, the first capacitor is disposed on the first surface, the second capacitor is disposed on the second surface, the first capacitor is disposed opposite to the second capacitor, a first end of the first connector is connected to the first surface, a second end of the first connector is connected to the second surface, and the first connector is configured to limit the first surface to be parallel to the second surface.

FIG. 1

**Description**

**CROSS-REFERENCE TO RELATED APPLICATIONS**

This application claims priority to Chinese Patent Application No. 202110771201.1, filed on July 8, 2021 in China, which is incorporated herein by reference in its entirety.

**TECHNICAL FIELD**

This application belongs to the field of electronic devices, and specifically relates to a pressure sensitive button and an electronic device.

**BACKGROUND**

Currently, most electronic devices use press-type mechanical buttons. A user may press a mechanical button on an electronic device to implement a corresponding touch operation. However, the mechanical button is generally disposed on a surface of the electronic device. This increases an overall stacking thickness of the electronic device.

**SUMMARY**

Embodiments of this application aim to provide a pressure sensitive button and an electronic device, to resolve a technical problem that an existing mechanical button increases an overall stacking thickness.

To resolve the technical problem, this application is implemented as follows:

According to a first aspect, an embodiment of this application provides a pressure sensitive button, including a first circuit board, a second circuit board, a first capacitor, a second capacitor, and a first connector, where

a first surface of the first circuit board is disposed opposite to a second surface of the second circuit board, the first capacitor is disposed on the first surface, the second capacitor is disposed on the second surface, the first capacitor is disposed opposite to the second capacitor, a first end of the first connector is connected to the first surface, and a second end of the first connector is connected to the second surface; and

the first connector is configured to limit the first surface to be parallel to the second surface.

According to a second aspect, an embodiment of this application provides an electronic device, including a housing, a second connector, and the pressure sensitive button according to the first aspect.

According to the embodiments of this application, a pressure sensitive button includes a first circuit board, a second circuit board, a first capacitor, a second capacitor, and a first connector, where a first surface of the first circuit board is disposed opposite to a second surface of the second circuit board, the first capacitor is disposed on the first surface, the second capacitor is disposed on the second surface, the first capacitor is disposed opposite to the second capacitor, a first end of the first connector is connected to the first surface, a second end of the first connector is connected to the second surface, and the first connector is configured to limit the first surface to be parallel to the second surface. The pressure sensitive button in the embodiments of this application does not need to be disposed on a surface of an electronic device. This decreases an overall stacking thickness of the electronic device, so that the electronic device is lighter and thinner.

**BRIEF DESCRIPTION OF DRAWINGS**

FIG 1 is a first structural diagram of a pressure sensitive button according to an embodiment of this application;

FIG 2 is a structural diagram of a pressure sensitive button in the prior art;

FIG 3 is a schematic diagram of a pressure sensitive button pressed with force according to an embodiment of this application;

FIG 4 is a second structural diagram of a pressure sensitive button according to an embodiment of this application;

FIG 5 is a third structural diagram of a pressure sensitive button according to an embodiment of this application;

FIG 6 is a fourth structural diagram of a pressure sensitive button according to an embodiment of this application;

FIG 7 is a fifth structural diagram of a pressure sensitive button according to an embodiment of this application; and

FIG 8 is a schematic diagram of a local structure of an electronic device according to an embodiment of this application.

**DESCRIPTION OF EMBODIMENTS**

The following clearly and completely describes technical solutions in embodiments of this application with reference to accompanying drawings in the embodiments of this application. Apparently, the described embodiments are some but not all of the embodiments of this application. All other embodiments obtained by a person of ordinary skill in the art based on the embodiments of this application without creative efforts shall fall within the protection scope of this application.

The terms "first", "second", and the like in this specification and the claims of this application are used to distinguish between similar objects instead of describing a specific order or sequence. It should be understood that the data used in such a way is interchangeable in proper circumstances so that the embodiments of this application can be implemented in an order other than the order illustrated or described herein. In addition, in this specification and the claims, "and/or" represents at least one of connected objects, and a character "/" generally represents an "or" relationship between associated objects.

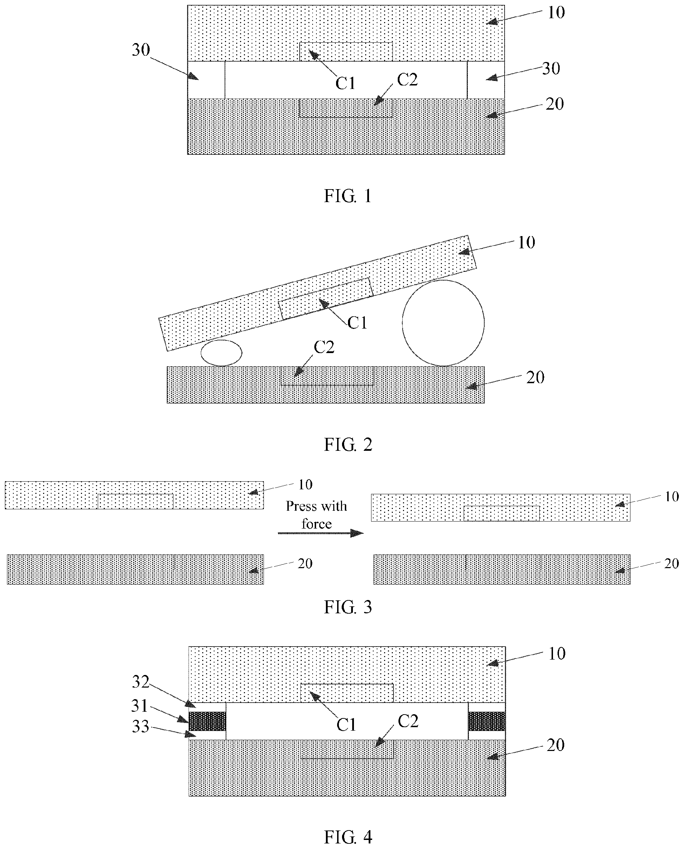

Refer to FIG 1 which is a first structural diagram of a pressure sensitive button according to an embodiment of this application. As shown in FIG 1, the pressure sensitive button in this embodiment of this application includes a first circuit board 10, a second circuit board 20, a first capacitor C1, a second capacitor C2, and a first connector 30.

A first surface of the first circuit board 10 is disposed opposite to a second surface of the second circuit board 20. The first capacitor C1 is disposed on the first surface. The second capacitor C2 is disposed on the second surface. The first capacitor C1 is disposed opposite to the second capacitor C2. A first end of the first connector 30 is connected to the first surface. A second end of the first connector 30 is connected to the second surface.

The first connector 30 is configured to limit the first surface to be parallel to the second surface.

In this embodiment, the first circuit board 10 may be a printed circuit board (Printed Circuit Board, PCB) or a flexible printed circuit (Flexible Printed Circuit, FPC); and the second circuit board 20 may be a printed circuit board or a flexible printed circuit. This is not specifically limited herein.

It should be understood that if the first circuit board 10 is a flexible printed circuit, a reinforcement plate is disposed on the side of the first circuit board 10 away from the second circuit board 20; and if the second circuit board 20 is a flexible printed circuit, a reinforcement plate is disposed on the side of the second circuit board 20 away from the first circuit board 10. Due to the additionally disposed reinforcement plates, strength of the circuit boards is improved. This facilitates overall assembly of the pressure sensitive button.

As shown in FIG 1, the first surface of the first circuit board 10 is disposed opposite and parallel to the second surface of the second circuit board 20. The first capacitor C1 is disposed on the first surface. The second capacitor C2 is disposed on the second surface. The first capacitor C1 is disposed opposite to the second capacitor C2. In this way, after the pressure sensitive button is pressed with force, the distance between the first circuit board 10 and the second circuit board 20 is changed. Accordingly, capacitances of the first capacitor C1 and the second capacitor C2 are also changed to respond to a press operation of a user.

In a possible case, as shown in FIG 2, the first circuit board 10 and the second circuit board 20 may be fastened to each other by welding with two solder balls.

However, the size of the solder ball is related to the temperature of welding, the thickness of a steel mesh, the viscosity of solder paste, the speed of a scraper during welding, and the like. In addition, if the distance between the two circuit boards is too large, a large quantity of solder paste needs to be used to form the solder balls. In this case, a relatively thick steel mesh needs to be used for printing with the solder paste. For example, a steel mesh whose thickness is 0.2 mm or 0.18 mm is used. Due to impacts of the foregoing factors, in an actual operation process, the sizes of the two solder balls are usually inconsistent. If the sizes of the two solder balls are inconsistent, the first circuit board 10 and the second circuit board 20 are not parallel to each other. As a result, after the pressure sensitive button is pressed with force, variations of capacitances cannot be measured accurately, which easily causes an accidental touch. This reduces the reliability of the pressure sensitive button.

To avoid the foregoing case, in this embodiment, the first connector 30 is disposed between the first circuit board 10 and the second circuit board 20. That the first connector 30 is configured to limit the first surface to be parallel to the second surface means that the first connector 30 is configured to limit the first circuit board 10 to be parallel to the second circuit board 20.

It should be understood that the first circuit board 10 being parallel to the second circuit board 20 means that the distance between the first circuit board 10 and the second circuit board 20 is within a preset range. Optionally, the distance between the first circuit board 10 and the second circuit board 20 is greater than or equal to 50 $\mu$m and less than or equal to 150 $\mu$m.

Further, refer to FIG 3 which is a schematic diagram of a pressure sensitive button pressed with force according to an embodiment of this application. As shown in FIG 3, before the pressure sensitive button is pressed with force, the distance between the first circuit board 10 and the second circuit board 20 is $d_0$; and after the pressure sensitive button is pressed with force, the distance between the first circuit board 10 and the second circuit board 20 is $d_F$. Herein, the difference between $d_0$ and $d_F$ may be defined as $\Delta d$. $\Delta d$ may also be understood as a variation of the distance between the first circuit board 10 and the second circuit board 20 after the pressure sensitive button is pressed with force. Therefore, a variation of a capacitance after the pressure sensitive button is pressed with force may be represented by using the following formula:

$$\Delta C = \frac{\varepsilon_r \times \varepsilon_0 \times s}{(d_0 \div \Delta d - 1) \times d_0},$$

where

$\Delta C$ is a variation of a capacitance; $\varepsilon_r$ and $\varepsilon_0$ are preset dielectric constants; S is an area by which the first circuit board 10 and the second circuit board 20 are disposed opposite to each other; $d_0$ is a distance between the first circuit board 10 and the second circuit board 20; and $\Delta d$ is a variation of the distance between the first circuit board 10 and the second circuit board 20 after the pressure sensitive button is pressed with force.

In this embodiment of this application, after a user presses the pressure sensitive button with force, the distance between two parallel circuit boards is changed. Therefore, capacitances of two capacitors that are disposed on the two parallel circuit boards and opposite to each other are changed to respond to the press operation of the user. The pressure sensitive button in the embodiments of this application does not need to be disposed on a surface of an electronic device. This decreases an overall stacking thickness of the electronic device, so that the electronic device is lighter and thinner.

Optionally, the first end of the first connector 30 is fastened to the first circuit board 10 by bonding, the second end of the first connector 30 is fastened to the second circuit board 20 by bonding, and the first circuit board 10 is electrically connected to the second circuit board 20 through the first connector 30.

Optionally, the first connector 30 is conductive adhesive.

In this embodiment, the first end of the first connector 30 is fastened to the first circuit board 10 by bonding according to a lamination process. The second end of the first connector 30 is fastened to the second circuit board 20 by bonding, so that the first circuit board 10 is parallel to the second circuit board 20. Moreover, the first circuit board 10 and the second circuit board 20 may also be electrically connected to each other through the first connector 30.

It should be understood that the thickness of the first connector 30 after lamination is less than the thickness of the first connector 30 before the lamination. For example, if the conventional thickness of the first connector 30 is 60 μm, that is, the thickness of the first connector 30 before the lamination is 60 μm, the thickness of the first connector 30 after the lamination may be 40 μm. If the conventional thickness of the first connector 30 is 40 μm, the thickness of the first connector 30 after the lamination may be 25 μm.

In an optional implementation, the first connector 30 is conductive adhesive, and the conductive adhesive is in a solidified state. It should be understood that in some embodiments, the first connector 30 may alternatively be made of another material that has an electricity conducting function. This is not specifically limited herein.

Optionally, the first connector 30 includes a metal reinforcement plate 31, a first conductive adhesive layer 32, and a second conductive adhesive layer 33; the first conductive adhesive layer 32 is disposed between the first circuit board 10 and the metal reinforcement plate 31; and the second conductive adhesive layer 33 is disposed between the second circuit board 20 and the metal reinforcement plate 31.

Refer to FIG 4 which is a second structural diagram of a pressure sensitive button according to an embodiment of this application. As shown in FIG 4, the first connector 30 includes the metal reinforcement plate 31, the first conductive adhesive layer 32, and the second conductive adhesive layer 33. The metal reinforcement plate 31 is disposed between the first conductive adhesive layer 32 and the second conductive adhesive layer 33. The first conductive adhesive layer 32 is fastened to the first circuit board 10 by bonding. The second conductive adhesive layer 33 is fastened to the second circuit board 20 by bonding. The first conductive adhesive layer 32 and the second conductive adhesive layer 33 are made of conductive adhesive. The metal reinforcement plate 31 may be made of stainless steel or another metal. This is not specifically limited herein.

In this embodiment, disposing the metal reinforcement plate 31 between the first conductive adhesive layer 32 and the second conductive adhesive layer 33 not only limits the first circuit board 10 to be parallel to the second circuit board 20, but also can decrease usage of conductive adhesive, thereby decreasing the production cost of the pressure sensitive button.

Optionally, the first connector 30 includes at least one of a first pad 34 that is disposed in a first welding region of the first circuit board 10 and a second pad 35 that is disposed in a second welding region of the second circuit board 20; the first pad 34 protrudes from the first surface of the first circuit board 10; and the second pad 35 protrudes from the second surface of the second circuit board 20.

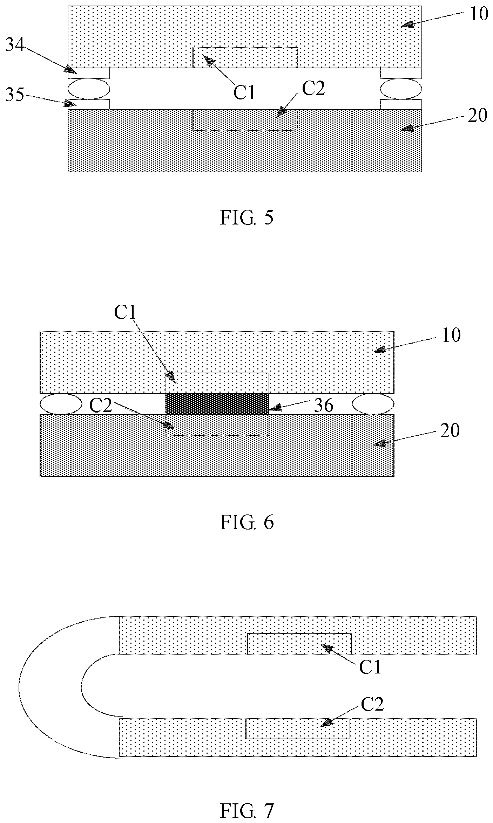

Refer to FIG 5 which is a third structural diagram of a pressure sensitive button according to an embodiment of this application. As shown in FIG 5, the first connector 30 includes the first pad 34 and the second pad 35. The first pad 34 is disposed in the first welding region of the first circuit board 10. The second pad 35 is disposed in the second welding region of the second circuit board 20. Disposing of the first pad 34 and the second pad 35 decreases the distance between the first circuit board 10 and the second circuit board 20 in a welding region. Solder balls are welded between the first pad 34 and the second pad 35, so that the first circuit board 10 and the second circuit board 20 are parallel to each other.

As described above, when the distance between the two circuit boards is too large, a relatively thick steel mesh needs to be used for printing with solder paste to form solder balls. This easily causes that the sizes of the solder balls are inconsistent. As a result, the two circuit boards are not parallel to each other.

In this embodiment, disposing of the first pad 34 and the second pad 35 decreases the distance between the first circuit board 10 and the second circuit board 20 in the welding region. For example, if both the first pad 34 and the second pad 35 are 25 μm high, the distance between the first circuit board 10 and the second circuit board 20 in the welding region may be decreased by 50 μm. In this case, a relatively thin steel mesh may be used for printing with solder paste to form solder balls whose sizes are consistent. This ensures that the two circuit boards are parallel to each other.

In an optional implementation, the first connector 30 is the first pad 34; and the first pad 34 protrudes from the first surface of the first circuit board 10.

In another optional implementation, the first connector 30 is the second pad 35; and the second pad 35 protrudes from the second surface of the second circuit board 20.

Optionally, the first connector 30 is the first pad 34, and the first pad 34 is fastened to the second welding region by welding;

the first connector 30 is the second pad 35, and the second pad 35 is fastened to the first welding region by welding; or

the first connector 30 includes the first pad 34 and the second pad 35, and the first pad 34 is fastened to the second pad 35 by welding.

In this embodiment, in a case that the first connector 30 is the first pad 34, solder balls may be welded between the first pad 34 and the second welding region, so that first pad 34 is fastened to the second welding region by welding. The first circuit board 10 and the second circuit board 20 are electrically connected to each other by using the first pad 34 and the solder balls.

In a case that the first connector 30 is the second pad 35, solder balls may be welded between the second pad 35 and the first welding region, so that second pad 35 is fastened to the first welding region by welding. The first circuit board 10 and the second circuit board 20 are electrically connected to each other by using the second pad 35 and the solder balls.

In a case that the first connector 30 includes the first pad 34 and the second pad 35, solder balls may be welded between the first pad 34 and the second pad 35, so that first pad 34 is fastened to the second pad 35 by welding. The first circuit board 10 and the second circuit board 20 are electrically connected to each other by using the first pad 34 and the second pad 35.

Optionally, the first connector 30 is a first elastic member 36; and the first circuit board 10 is fastened to the second circuit board 20 by welding.

Optionally, a first end of the first elastic member 36 is connected to the first capacitor C1; and a second end of the first elastic member 36 is connected to the second capacitor C2.

Refer to FIG 6. As shown in FIG 6, in this embodiment, the first connector 30 is a first elastic member 36. By disposing the first elastic member 36, the first circuit board 10 is kept parallel to the second circuit board 20. To prevent the first elastic member 36 from deforming in a welding process, the first elastic member 36 is made of a high temperature-resistant elastic material, for example, all-aromatic polyimide, a high temperature-resistant polyurethane elastomer, or another material.

The first end of the first elastic member 36 is connected to the first capacitor C1; the second end of the first elastic member 36 is connected to the second capacitor; and the first circuit board 10 is fastened to the second circuit board 20 by welding. As shown in FIG 6, solder balls may be welded between the first circuit board 10 and the second circuit board 20 to fasten the first circuit board 10 and the second circuit board 20. As shown in FIG 6, the distance between the first circuit board 10 and the second circuit board 20 is the same as the thickness of the first elastic member 36.

It should be understood that in some embodiments, the first elastic member 36 is not disposed between the first capacitor C1 and the second capacitor C2. In this case, it may also be ensured that the first circuit board 10 and the second circuit board 20 are parallel to each other.

In a possible case, the first circuit board 10 and the second circuit board 20 are a same circuit board and are flexible printed circuits. In this case, the circuit board may be bent to form two surfaces that are parallel to each other, as shown in FIG 7 which is a fifth structural diagram of a pressure sensitive button according to an embodiment of this application.

In the circuit board shown in FIG 7, two surfaces of the circuit board are parallel to each other. The first capacitor C1 is disposed on one of the surfaces of the circuit board. The second capacitor C2 is disposed on the other surface of the circuit board. The first capacitor C1 is disposed opposite to the second capacitor C2.

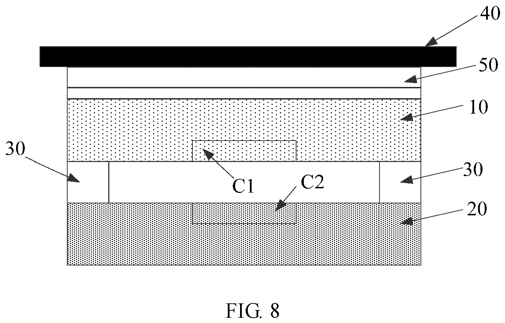

Refer to FIG 8 which is a schematic diagram of a local structure of an electronic device according to an embodiment of this application. In this embodiment of this application, an electronic device is further provided. The electronic device includes a housing 40, a second connector 50, and the pressure sensitive button described above. The second connector 50 is disposed between the housing 40 and the pressure sensitive button. The second connector 50 is configured to limit the pressure sensitive button to be fastened to the housing 40.

As shown in FIG 8, the electronic device includes the housing 40, the second connector 50, and the pressure sensitive button. The pressure sensitive button includes the first circuit board 10 and the second circuit board 20 that are parallel to each other. The first capacitor C1 is disposed on the first circuit board 10. The second capacitor C2 is disposed on the second circuit board 20.

When a user presses the pressure sensitive button on the electronic device, the distance between the first circuit board 10 and the second circuit board 20 is changed. Accordingly, a capacitance between the first capacitor C1 and the second capacitor C2 is also changed to respond to the press operation of the user based on a variation of the capacitance.

As described above, if the first circuit board 10 in the pressure sensitive button is a flexible printed circuit, a reinforcement plate may be disposed on the side of the first circuit board 10 away from the second circuit board 20. One end of the second connector 50 is connected to the housing 40, and the other end of the second connector 50 is connected to the reinforcement plate, so that the pressure sensitive button is fastened to the housing 40.

It should be understood that for a specific implementation of the pressure sensitive button, refer to the foregoing descriptions, and a same technical effect can be achieved. To avoid repetition, details are not described again.

Optionally, the second connector 50 may be double-sided adhesive. However, the bonding force of double-sided adhesive is decreased in an environment having relatively high temperature or relatively high humidity. This may cause the pressure sensitive button to fall off from the housing 40. In addition, in a case that the electronic device suffers an external force, the pressure sensitive button may also fall off from the housing 40.

To resolve the foregoing possible technical problem, the second connector 50 may be provided as a second elastic member.

Optionally, the second connector 50 is a second elastic member; a first end of the second elastic member is connected to the housing 40; and a second end of the second elastic member is connected to the pressure sensitive button.

In an optional implementation, the second elastic member is a spring. The first end of the second elastic member is connected to the housing 40. The second end of the second elastic member is connected to the pressure sensitive button. Because the spring is insusceptible to temperature and humidity, the pressure sensitive button will not fall off from the housing 40 even in an environment having relatively high temperature and relatively high humidity. When the electronic device suffers an external force, the second elastic member may also perform a buffering function to prevent the pressure sensitive button from falling off from the housing 40.

In this embodiment of the present invention, the foregoing electronic device may be a computer (Computer), a mobile phone, a tablet personal computer (Tablet Personal Computer), a laptop computer (Laptop Computer), a personal digital assistant (personal digital assistant, PDA), a mobile Internet device (Mobile Internet Device, MID), a wearable device (Wearable Device), an e-book reader, a navigator, a digital camera, or the like.

The embodiments of this application are described above with reference to the accompanying drawings. However, this application is not limited to the foregoing specific implementations. The foregoing specific implementations are merely illustrative instead of restrictive. Under the enlightenment of this application, a person of ordinary skill in the art may make many forms without departing from the essence of this application and the protection scope of the claims, all of which fall within the protection of this application.

**Claims**

1. A pressure sensitive button, comprising a first circuit board, a second circuit board, a first capacitor, a second capacitor, and a first connector, wherein

   a first surface of the first circuit board is disposed opposite to a second surface of the second circuit board, the first capacitor is disposed on the first surface, the second capacitor is disposed on the second surface, the first capacitor is disposed opposite to the second capacitor, a first end of the first connector is connected to the first surface, and a second end of the first connector is connected to the second surface; and
   the first connector is configured to limit the first surface to be parallel to the second surface.

2. The pressure sensitive button according to claim 1, wherein the first end of the first connector is fastened to the first circuit board by bonding, the second end of the first connector is fastened to the second circuit board by bonding, and the first circuit board is electrically connected to the second circuit board through the first connector.

3. The pressure sensitive button according to claim 2, wherein the first connector is conductive adhesive.

4. The pressure sensitive button according to claim 1, wherein the first connector comprises a metal reinforcement plate, a first conductive adhesive layer, and a second conductive adhesive layer, the first conductive adhesive layer is disposed between the first circuit board and the metal reinforcement plate, and the second conductive adhesive layer is disposed between the second circuit board and the metal reinforcement plate.

5. The pressure sensitive button according to claim 1, wherein the first connector comprises at least one of a first pad that is disposed in a first welding region of the first circuit board and a second pad that is disposed in a second welding region of the second circuit board, the first pad protrudes from the first surface of the first circuit board, and the second pad protrudes from the second surface of the second circuit board.

6. The pressure sensitive button according to claim 5, wherein the first connector is the first pad, and the first pad is fastened to the second welding region by welding;

   the first connector is the second pad, and the second pad is fastened to the first welding region by welding; or
   the first connector comprises the first pad and the second pad, and the first pad is fastened to the second pad by welding.

7. The pressure sensitive button according to claim 1, wherein the first connector is a first elastic member, and the first circuit board is fastened to the second circuit board by welding.

8. The pressure sensitive button according to claim 7, wherein a first end of the first elastic member is connected to the first capacitor, and a second end of the first elastic member is connected to the second capacitor.

9. An electronic device, wherein the electronic device comprises a housing, a second connector, and the pressure sensitive button according to any one of claims 1 to 8, the second connector is disposed between the housing and the pressure sensitive button, and the second connector is configured to limit the pressure sensitive button to be fastened to the housing.

10. The electronic device according to claim 9, wherein the second connector is a second elastic member, a first end of the second elastic member is connected to the housing, and a second end of the second elastic member is connected to the pressure sensitive button.

FIG. 1

FIG. 2

FIG. 3

FIG. 4

34

35

10

C1      C2

20

FIG. 5

C1

10

C2      36

20

FIG. 6

C1

C2

FIG. 7

FIG. 8

## INTERNATIONAL SEARCH REPORT

| International application No. |
|---|
| **PCT/CN2022/103334** |

**A. CLASSIFICATION OF SUBJECT MATTER**

H03K 17/975(2006.01)i; H03K 17/96(2006.01)i

According to International Patent Classification (IPC) or to both national classification and IPC

**B. FIELDS SEARCHED**

Minimum documentation searched (classification system followed by classification symbols)

H03K

Documentation searched other than minimum documentation to the extent that such documents are included in the fields searched

Electronic data base consulted during the international search (name of data base and, where practicable, search terms used)

CNABS; CNTXT; CNKI; WPABS; DWPI; USTXT; WOTXT; EPTXT: 压感, 按键, 第一, 第二, 电容, 电路板, PCB, 平行, 相对, 连接件, 厚度, pressure sensitive, button, first, second, capacitance, circuit board, parallel, opposite, connector, thickness

**C. DOCUMENTS CONSIDERED TO BE RELEVANT**

| Category* | Citation of document, with indication, where appropriate, of the relevant passages | Relevant to claim No. |
|---|---|---|
| PX | CN 113346890 A (VIVO COMMUNICATION TECHNOLOGY CO., LTD.) 03 September 2021 (2021-09-03)<br>claims 1-10, and description, paragraphs [0020]-[0068] | 1-10 |
| X | CN 206282307 U (NANCHANG OUFEI BIOLOGICAL IDENTIFICATION TECHNOLOGY CO., LTD.) 27 June 2017 (2017-06-27)<br>description, paragraphs [0028]-[0045], and figures 1-4 | 1-10 |
| X | WO 2020004651 A1 (SONY CORP.) 02 January 2020 (2020-01-02)<br>description, paragraphs [0013]-[0165], and figures 1-23 | 1-10 |
| A | CN 108346537 A (VIVO COMMUNICATION TECHNOLOGY CO., LTD.) 31 July 2018 (2018-07-31)<br>entire document | 1-10 |
| A | CN 204808299 U (VIVO COMMUNICATION TECHNOLOGY CO., LTD.) 25 November 2015 (2015-11-25)<br>entire document | 1-10 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 September 2022** | **21 September 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/103334**

| Patent document cited in search report | | | Publication date (day/month/year) | Patent family member(s) | | | Publication date (day/month/year) |
|---|---|---|---|---|---|---|---|
| CN | 113346890 | A | 03 September 2021 | None | | | |
| CN | 206282307 | U | 27 June 2017 | CN | 108256395 | A | 06 July 2018 |
| WO | 2020004651 | A1 | 02 January 2020 | JP | WO2020004651 | A1 | 08 July 2021 |
| | | | | US | 2021278293 | A1 | 09 September 2021 |
| CN | 108346537 | A | 31 July 2018 | CN | 108346537 | B | 18 February 2020 |
| CN | 204808299 | U | 25 November 2015 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110771201